# EUROPEAN PATENT APPLICATION

(11) **EP 4 092 729 A2**
(43) Date of publication of application: **23.11.2022**
(21) Application number: 22173990.7
(22) Date of filing: 18.05.2022
(51) Int. Cl.: H01L 23/40, H01L 23/32, H05K 1/02

(54) **BOARD, ELECTRONIC DEVICE, AND MANUFACTURING METHOD**

(30) Priority: 20.05.2021 CN 202110551666
(71) Applicant: Huawei Technologies Co., Ltd., Shenzhen, Guangdong 518129 (CN)
(72) Inventor: LIANG, Zhaokuan, Shenzhen, 518129 (CN); ZHANG, Liang, Shenzhen, 518129 (CN); JIAO, Zelong, Shenzhen, 518129 (CN); ZHAO, Yatao, Shenzhen, 518129 (CN); LI, Chunyang, Shenzhen, 518129 (CN)
(74) Representative: Thun, Clemens

(57) **Abstract**

This application discloses a board, an electronic device, and a manufacturing method, and pertains to the field of bare die package technologies. The board includes a PCB assembly, a bare die, a reinforcing frame, a heat sink, and fasteners. Both the bare die and the reinforcing frame are located on a surface of the PCB assembly, the bare die is located in the reinforcing frame, and the reinforcing frame is fixedly connected to the PCB assembly by using the fastener. The heat sink is located on a surface of the bare die that is away from the PCB assembly, and the heat sink is fixedly connected to the reinforcing frame by using the fastener.

## Description

### TECHNICAL FIELD

This application relates to the field of bare die package technologies, and in particular, to a board, an electronic device, and a manufacturing method.

### BACKGROUND

Aboard of an electronic device mainly includes a printed circuit board (printed circuit board, PCB) assembly, a bare die, and a heat sink. The bare die is welded to a surface of the PCB assembly. The heat sink is located on a surface of the bare die that is away from the PCB assembly.

When a board is in transit or when a temperature of the board is relatively high, a PCB assembly of the board is prone to deform. Once the PCB assembly is deformed, a connection between a bare die and the PCB assembly is easy to crack, resulting in poor reliability of a connection between the bare die and the PCB assembly.

### SUMMARY

This application provides a board, an electronic device, and a manufacturing method, which can resolve a problem in a related technology. The technical solutions are as follows.

According to one aspect, a board is provided. The board includes a PCB assembly, a bare die, a reinforcing frame, a heat sink, and fasteners;
both the bare die and the reinforcing frame are located on a surface of the PCB assembly, the bare die is located in the reinforcing frame, and the reinforcing frame is fixedly connected to the PCB assembly by using the fastener; and
the heat sink is located on a surface of the bare die that is away from the PCB assembly, and the heat sink is fixedly connected to the reinforcing frame by using the fastener.

The PCB assembly may include a PCB and a protection plate. The protection plate may also be referred to as a front panel, and serves as a base of the board. The PCB is fastened to a surface of the protection plate.

In the solution illustrated in this application, the reinforcing frame is located on a surface of the PCB in the PCB assembly and surrounds a periphery of the bare die. In this way, the reinforcing frame can increase rigidity of the PCB at a position corresponding to the bare die. Therefore, deformation of the PCB at the position corresponding to the bare die can be mitigated. Once the deformation of the PCB at the position corresponding to the bare die is relatively small, or the PCB even does not deform, reliability of a connection between the bare die and the PCB can be improved.

In a possible implementation, the fasteners include first fasteners and second fasteners;
the first fastener passes through the reinforcing frame and is fastened in the PCB assembly; and
the second fastener passes through the heat sink and is fastened in the reinforcing frame, and a depth of a part, of the second fastener that enters the reinforcing frame is less than or equal to a thickness of the reinforcing frame.

In the solution illustrated in this application, the reinforcing frame is fixedly connected to the PCB assembly by using the first fastener, and the heat sink is fixedly connected to the reinforcing frame by using the second fastener. The PCB in the PCB assembly is provided with a via for the first fastener to pass through, and the second fastener does not pass through the PCB. Therefore, compared with a case in which the reinforcing frame is fastened to the protection plate by using screws and the heat sink is also fastened to the protection plate by using screws, it is clearly that, in this application, a quantity of vias on the PCB can be reduced, and the reduction of the quantity of vias on the PCB facilitates routing and component mounting on the surface of the PCB.

In a possible implementation, the second fastener includes a screw and a first elastic component; and
the screw passes through the heat sink and is fastened in the reinforcing frame, a depth of a part, of the screw that enters the reinforcing frame is less than or equal to the thickness of the reinforcing frame, and the first elastic component is compressed between a screw cap of the screw and the heat sink.

In the solution illustrated in this application, the reinforcing frame is provided with threaded holes. The threaded hole may be a through hole with a thread on an inner wall, or may be a blind via with a thread on an inner wall. This is not limited in this embodiment. In this way, the screw may pass through the heat sink and be screwed into the threaded hole in the reinforcing frame, and the depth of the screw that enters the reinforcing frame is less than or equal to the thickness of the reinforcing frame, so that the screw does not pass through the threaded hole and enter the PCB.

In the solution illustrated in this application, the first elastic component is compressed between the screw cap of the screw and the heat sink, so that not only a tolerance between the bare die and the heat sink can be eliminated, but also the bare die can reach close contact with a bottom of the heat sink, so as to accelerate heat transfer between the bare die and the heat sink, and accelerate heat dissipation for the bare die.

In a possible implementation, the fastener passes through the heat sink and the reinforcing frame, and is fastened in the PCB assembly.

In the solution illustrated in this application, the fastener passes through the heat sink and the reinforcing frame, and is fastened in the protection plate of the PCB assembly. The heat sink and the reinforcing frame share the fastener. Therefore, compared with a case in which the reinforcing frame is fastened to the protection plate by using screws and the heat sink is also fastened to the protection plate by using screws, it is clearly that, in this application, a quantity of vias on the PCB can be reduced, and the reduction of the quantity of vias on the PCB facilitates routing on the surface of the PCB and implements high-density routing on the surface of the PCB.

In a possible implementation, the fastener includes a stud, a nut, and a second elastic component, and an outer wall of the stud has a boss;
a first end of the stud passes through the reinforcing frame and is fastened in the PCB assembly, and the boss is located on a surface of the reinforcing frame that is away from the PCB assembly; and a second end of the stud passes through the heat sink; and
the nut is fastened at a position of the stud that is near the second end, and the second elastic component is compressed between the nut and the heat sink.

In the solution illustrated in this application, the protection plate of the PCB assembly may have threaded holes. The threaded hole may be a through hole with a thread on an inner wall, or may be a blind via with a thread on an inner wall. This is not limited in this embodiment. In this way, the first end of the stud may pass through the reinforcing frame and be screwed into the threaded hole in the protection plate, and the boss is located on the surface of the reinforcing frame that is away from the PCB assembly, so that the reinforcing frame is fixedly connected to the protection plate. The second end of the stud extends out of the heat sink, and the second elastic component is placed on a surface of the heat sink that is away from the bare die. The nut is screwed at the position of the stud that is near the second end, so that the second elastic component is compressed between the heat sink and the nut, and the heat sink canbe fixedly connected to the reinforcing frame. In addition, the second elastic component eliminates a gap between the heat sink and the bare die, so that the heat sink and the bare die are maintained in a fitted state, to accelerate heat transfer between the bare die and the heat sink.

In a possible implementation, the second elastic component includes a telescopic member and a housing;
the housing is sleeved outside the stud and located above the boss, and the housing is snapped into the nut; and
the telescopic member is located in the housing and is compressed between the housing and the nut.

The housing serves to protect the second elastic component.

In the solution illustrated in this application, the housing can move up and down along an axial direction of the stud relative to the nut in a telescopic motion of the telescopic member, and a movement stroke falls within a preset range. In this way, the second elastic component can provide a buffering effect to eliminate the tolerance between the heat sink and the bare die, and the heat sink and the bare die can be maintained in the fitted state.

In a possible implementation, an inner wall of the housing has a protrusion, an outer wall of the nut has a groove, a depth of the groove is greater than a height of the protrusion, and the protrusion is located in the groove.

In the solution illustrated in this application, the protrusion cooperates with the groove, so that the housing can be fixedly connected to the nut. The height of the protrusion is set to be less than the depth of the groove along the axial direction of the stud, so that the housing can move up and down along the axial direction of the stud with extension and retraction of the telescopic member, and the second elastic component has the buffering effect.

In a possible implementation, there are a plurality of bare dies and a plurality of heat sinks;
the reinforcing frame is grid-shaped and includes a plurality of grids, and each bare die is located in one grid; and
the plurality of heat sinks each are fixedly connected to the reinforcing frame.

In the solution illustrated in this application, the plurality of bare dies share one reinforcing frame. Compared with a case in which bare dies one to one correspond to reinforcing frames, it is clearly that, in this application, an area occupied by the reinforcing frame on the surface of the PCB can be reduced, and a quantity of vias disposed on the PCB for fastening the reinforcing frame can be reduced.

In addition, the plurality of bare dies share one reinforcing frame. In this way, an area of the reinforcing frame is relatively large. When the reinforcing frame is fastened to the surface of the PCB assembly, not only rigidity of the PCB at the bare die can be increased, but also overall rigidity of the PCB can be increased, to mitigate PCB deformation.

In addition, because the plurality of heat sinks are fastened to the reinforcing frame, the reinforcing frame can be configured to fasten the plurality of heat sinks together, to save a substrate configured to fasten a plurality of heat sinks together. Once the substrate configured to fasten a plurality of heat sinks is saved, a space occupied by the substrate on the board can be released, and the released space can be used to extend a height of heat dissipation fins of the heat sink, so as to increase an area of the heat dissipation fins. This further increases a heat dissipation area of the heat sink, and improves a heat dissipation effect of the heat sink.

In a possible implementation, a material of the reinforcing frame is a metal; and
the board further includes an insulation layer, and the insulation layer is located between the reinforcing frame and the PCB assembly.

In the solution illustrated in this application, if the material of the reinforcing frame is a metal, and the surface of the PCB has routes and components, to prevent the reinforcing frame from affecting the routes and the components on the surface of the PCB, an insulation layer may also be correspondingly mounted between the reinforcing frame and the PCB to isolate the reinforcing frame from the routes on the surface of the PCB. The reinforcing frame closely fits with the insulation layer, and the insulation layer closely fits with the PCB, to effectively improve the rigidity of the PCB at the bare die.

According to another aspect, a board manufacturing method is provided. The method is applied to the foregoing board, and the method includes:
welding a bare die to a surface of a PCB assembly;
placing a reinforcing frame on the surface of the PCB assembly, where the reinforcing frame surrounds a periphery of the bare die;
placing a heat sink on a surface of the bare die that is away from the PCB assembly; and
fixedly connecting, by using fasteners, the reinforcing frame to the PCB assembly and the heat sink to the reinforcing frame.

In the solution illustrated in this application, the bare die is welded to a surface of a PCB in the PCB assembly by using solder, the reinforcing frame is located on the surface of the PCB and surrounds a periphery of the bare die, and the reinforcing frame is fixedly connected to a protection plate of the PCB assembly by using the fastener. The reinforcing frame can increase rigidity of the PCB assembly at the corresponding bare die, so as to mitigate deformation of the PCB assembly at the bare die, and improve reliability of a connection between the bare die and the PCB assembly.

In the solution illustrated in this application, the heat sink is located on a surface of the bare die that is away from the PCB, and a bottom of the heat sink closely fits with the bare die, so that the heat sink performs heat dissipation for the bare die. The heat sink is fixedly connected to the reinforcing frame by using the fastener. The reinforcing frame is fixedly connected to the protection plate of the PCB assembly, and the heat sink is fixedly connected to the reinforcing frame. Compared with a case in which the reinforcing frame is fixedly connected to the protection plate of the PCB assembly and the heat sink is also fixedly connected to the protection plate of the PCB assembly, it is clearly that, in this application, a quantity of vias on the PCB can be reduced, and the reduction of the quantity of vias on the PCB facilitates routing and component mounting on the PCB and implements high-density routing on the surface of the PCB.

In a possible implementation, the fasteners include first fasteners and second fasteners;
the fixedly connecting, by using fasteners, the reinforcing frame to the PCB assembly and the heat sink to the reinforcing frame includes:
making the first fastener pass through the reinforcing frame, and fastening the first fastener in the PCB assembly; and
making the second fastener pass through the heat sink, and fastening the second fastener in the reinforcing frame.

In the solution illustrated in this application, the first fastener and the second fastener each may be a screw. One screw passes through the reinforcing frame and is screwed into the protection plate of the PCB assembly, and the other screw passes through the heat sink and is screwed into the reinforcing frame instead of the protection plate. Therefore, the quantity of vias on the PCB in the PCB assembly can be reduced, and the reduction of the quantity of vias on the PCB facilitates routing and component mounting on the PCB and implements high-density routing on the surface of the PCB.

In a possible implementation, the fixedly connecting, by using fasteners, the reinforcing frame to the PCB assembly and the heat sink to the reinforcing frame includes:
making the fastener pass through the heat sink and the reinforcing frame, and fastening the fastener in the PCB assembly.

In the solution illustrated in this application, the fastener passes through the heat sink and the reinforcing frame, and is fastened in the protection plate of the PCB assembly. The heat sink and the reinforcing frame share the fastener. Therefore, compared with a case in which the reinforcing frame is fastened to the protection plate by using screws and the heat sink is also fastened to the protection plate by using screws, it is clearly that, in this application, a quantity of vias on the PCB can be reduced, and the reduction of the quantity of vias on the PCB facilitates routing on the surface of the PCB and implements high-density routing on the surface of the PCB.

In a possible implementation, the fastener includes a stud, a nut, and a second elastic component, and an outer wall of the stud has a boss; and
the making the fastener pass through the heat sink and the reinforcing frame, and fastening the fastener in the PCB assembly includes:
making a first end of the stud pass through the reinforcing frame and fastening the first end of the stud in the PCB assembly, where the boss is located on a surface of the reinforcing frame that is away from the PCB assembly; and making a second end of the stud pass through the heat sink; and
fastening the nut at a position of the stud that is near the second end, where the second elastic component is compressed between the heat sink and the nut.

According to another aspect, an electronic device is provided. The electronic device includes the foregoing board.

In the solution illustrated in this application, the electronic device may be any device including a bare die, for example, a communications device or a server device. The electronic device includes the foregoing board.

The board includes a reinforcing frame. The reinforcing frame is located on a surface of a PCB assembly and surrounds the bare die. The reinforcing frame can increase rigidity of the PCB assembly at the corresponding bare die, so as to mitigate deformation of the PCB assembly at the bare die, and improve reliability of a connection between the bare die and the PCB assembly.

In addition, the reinforcing frame is fixedly connected to the PCB assembly, and a heat sink that performs heat dissipation for the bare die is fixedly connected to the reinforcing frame. Compared with a case in which the reinforcing frame is fixedly connected to the PCB assembly and the heat sink is also fixedly connected to the PCB assembly, it is clearly that, in this application, a quantity of vias on the PCB assembly can be reduced, and the reduction of the quantity of vias on the PCB assembly facilitates routing and component mounting on the PCB assembly and implements high-density routing on a surface of the PCB assembly.

### BRIEF DESCRIPTION OF DRAWINGS

FIG. 1 is a schematic exploded diagram of a structure of a board according to this application;
FIG. 2 is a schematic diagram of a structure of a board according to this application;
FIG. 3 is a schematic exploded diagram of a structure of a board according to this application;
FIG. 4 is a schematic diagram of a structure of a board according to this application;
FIG. 5 is a schematic diagram of a structure of a fastener according to this application;
FIG. 6 is a schematic exploded diagram of a structure of a board according to this application; and
FIG. 7 is a schematic diagram of a partial structure of a reinforcing frame of a board according to this application.

Legend description:
1. PCB assembly; 11. PCB; 12. protection plate; 121. pillar;
2. bare die;
3. reinforcing frame; 30. grid;
4. heat sink; 41. heat dissipation substrate; 42. heat dissipation fin;
5. fastener; 51. first fastener; 52. second fastener;
53. stud; 531. boss; 54. nut; 55. second elastic component;
551. telescopic member; 552. housing; 553. protrusion;
554. first housing; 555. second housing; and
6. protection frame

### DESCRIPTION OF EMBODIMENTS

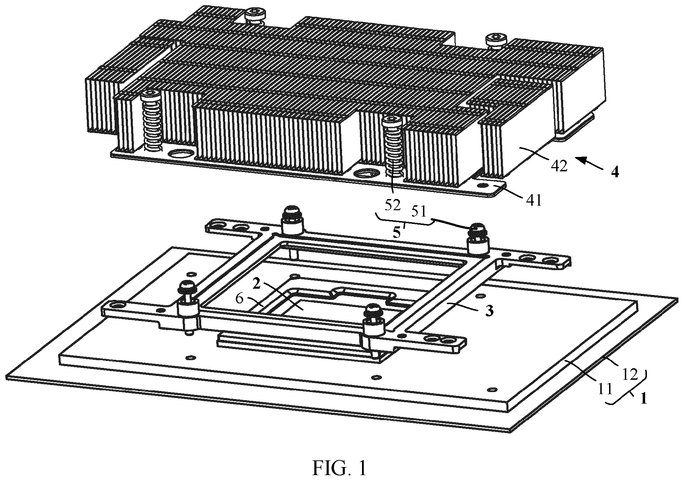

An embodiment of this application provides a board of an electronic device. As shown in FIG. 1, the board includes a printed circuit board (Printed Circuit Board, PCB) assembly 1, a bare die 2, a reinforcing frame 3, a heat sink 4, and fasteners 5. With respect to a positional relationship, both the bare die 2 and the reinforcing frame 3 are located on a surface of the PCB assembly 1, the bare die 2 is located in the reinforcing frame 3, and the heat sink 4 is located on a surface of the bare die 2 that is away from the PCB assembly. With respect to a fastening relationship, the reinforcing frame 3 is fixedly connected to the PCB assembly 1 by using the fastener 5, and the heat sink 4 is fixedly connected to the reinforcing frame 3 by using the fastener 5.

As shown in FIG. 1, the PCB assembly 1 may include a PCB 11 and a protection plate 12. The protection plate 12 may also be referred to as a front panel, and serves as a base of the board. The PCB 11 is fastened to a surface of the protection plate 12, for example, the PCB 11 is fixedly connected to the surface of the protection plate 12 by using adhesive or screws. When the PCB 11 is fastened to the surface of the protection plate 12 by using screws, if a thickness of the protection plate 12 is relatively small and a threaded hole is difficult to form, pillars may be disposed on a surface of the protection plate 12 that is near the PCB 11, and a threaded hole may be disposed in the pillar. In this way, the screw can pass through the PCB 11 and be screwed into the threaded hole of the pillar, so that the PCB 11 is fixedly connected to the protection plate 12. In addition, due to existence of the pillars, a gap exists between the PCB 11 and the protection plate 12. Therefore, routes may be laid out and some components may be mounted on a surface of the PCB 11 that is near the protection plate 12.

The bare die 2 may also be referred to as a die, and is prepared by using semiconductor components.

The reinforcing frame 3 may also be referred to as a reinforcing framework, surrounds a periphery of the bare die 2, and may be prepared by using a material of a metal.

The heat sink 4 is an apparatus for performing heat dissipation for the bare die 2, and is mostly prepared by using a metal of aluminum or copper. As shown in FIG. 1, the heat sink 4 may include a heat dissipation substrate 41 and heat dissipation fins 42. The heat dissipation fins 42 are located on a surface of the heat dissipation substrate 41. For example, the heat dissipation fins 42 may be welded to the surface of the heat dissipation substrate 41. A larger quantity of heat dissipation fins 42 and a larger area of the heat dissipation fins 42 lead to a larger heat dissipation area of the heat sink 4 and a better heat dissipation effect thereof.

In an example, the bare die 2 is located on the surface of the PCB 11, and a protection member for protecting the bare die 2 is usually provided in the periphery of the bare die 2. As shown in FIG. 1, the board further includes a protection frame 6, and the protection frame 6 is located on the surface of the PCB 11 and surrounds the periphery of the bare die 2. The protection frame 6 is not only configured to protect the bare die 2, but also used as a shielding apparatus, which is configured to shield an interference signal in an environment around the bare die 2, and is further configured to shield a signal of the bare die 2 to mitigate interference with a component around.

In an example, the bare die 2 is usually welded to the surface of the PCB assembly 1 by using solder. For example, the surface of the bare die 2 has solder balls, and the surface of the PCB 11 in the PCB assembly 1 has pads. The solder balls of the bare die 2 are welded to the pads of the PCB 11 by using solder to implement an electrical connection between the bare die 2 and the PCB 11.

When the PCB 11 is heated and has a temperature rise, or when the board is in transit, the PCB 11 may deform. Once the PCB 11 deforms, reliability of the connection between the bare die 2 and the PCB 11 deteriorates. This causes instability of the electrical connection between the bare die 2 and the PCB 11.

To improve the stability of the connection between the bare die 2 and the PCB 11, correspondingly, the reinforcing frame 3 is located on the surface of the PCB 11 in the PCB assembly 1 and surrounds the periphery of the bare die 2. In this way, the reinforcing frame 3 can increase rigidity of the PCB 11 at a position corresponding to the bare die 2. Therefore, deformation of the PCB 11 at the position corresponding to the bare die 2 can be mitigated. Once the deformation of the PCB 11 at the position corresponding to the bare die 2 is relatively small, or the PCB 11 even does not deform, the reliability of the connection between the bare die 2 and the PCB 11 can be improved.

Because the reinforcing frame 3 is used for improving the rigidity of the PCB 11, correspondingly, the reinforcing frame 3 may closely fit with the PCB 11, to effectively improve the rigidity of the PCB 11 at the bare die 2.

Alternatively, if the material of the reinforcing frame 3 is a metal, and the surface of the PCB 11 has routes and components, to prevent the reinforcing frame 3 from affecting the routes and the components on the surface of the PCB 11, an insulation layer may be correspondingly mounted between the reinforcing frame 3 and the PCB 11 to isolate the reinforcing frame 3 from the routes on the surface of the PCB 11. The reinforcing frame 3 closely fits with the insulation layer, and the insulation layer closely fits with the PCB 11, to effectively improve the rigidity of the PCB 11 at the bare die 2.

With respect to a fastening relationship between the PCB 11, the protection plate 12, the bare die 2, the reinforcing frame 3, and the heat sinks 4, as described above, the PCB 11 is fastened to the surface of the protection plate 12 by using screws or adhesive, and the bare die 2 is welded to a surface of the PCB 11 that is away from the protection plate 12.

Then, for the reinforcing frame 3 and the heat sink 4, the reinforcing frame 3 is fixedly connected to the protection plate 12 of the PCB assembly 1 by using the fastener 5, and the heat sink 4 is fixedly connected to the reinforcing frame 3 by using the fastener 5.

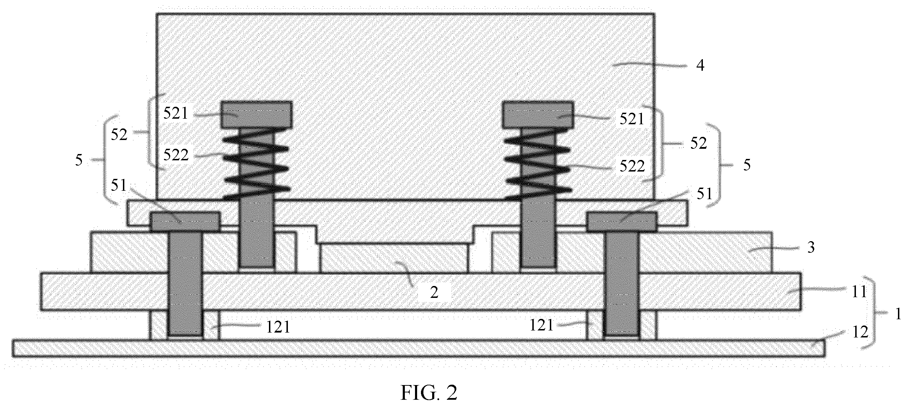

The fastener 5 may include two structural forms. For one structural form of the fastener 5, refer to FIG. 2, in which the fasteners 5 include first fasteners 51 and second fasteners 52. In this case, the reinforcing frame 3 is fixedly connected to the protection plate 12 of the PCB assembly 1 by using the first fastener 51 in the fasteners 5. The heat sink 4 is fixedly connected to the reinforcing frame 3 by using the second fastener 52 in the fasteners 5, and a depth of a part, of the second fastener 52 that enters the reinforcing frame 3 is less than or equal to a thickness of the reinforcing frame 3.

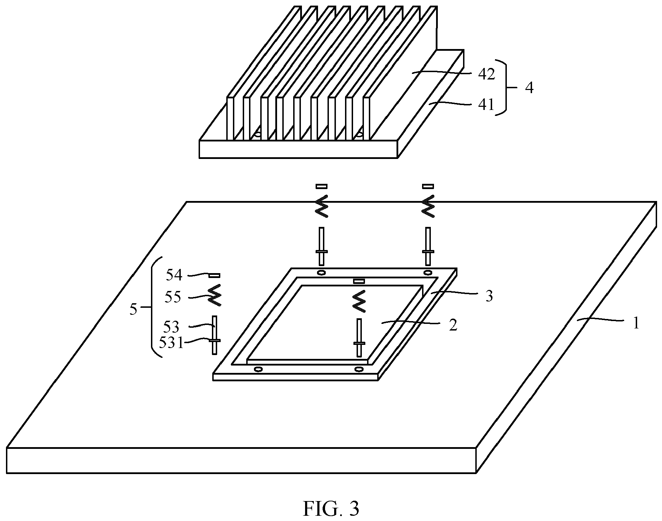

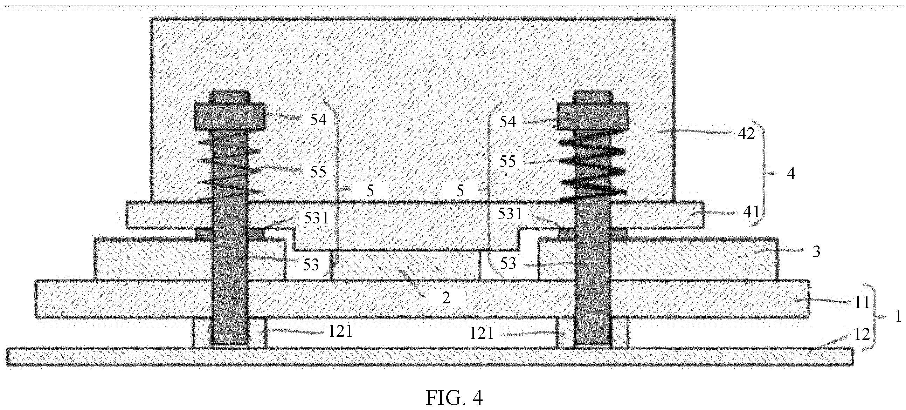

For the other structural form of the fastener 5, refer to FIG. 3 and FIG. 4, in which the fastener 5 passes through the heat sink 4 and the reinforcing frame 3, and is fastened in the protection plate 12 of the PCB assembly 1.

Compared with a case in which the reinforcing frame 3 is fastened to the protection plate 12 by using screws and the heat sink 4 is also fastened to the protection plate 12 by using screws, in this application, a quantity of vias on the PCB 11 of the PCB assembly 1 can be reduced, regardless of whether the heat sink 4 is fastened to the reinforcing frame 3 by using the second fastener 52 and the reinforcing frame 3 is fastened to the protection plate 12 by using the first fastener 51, or the fastener 5 passes through the heat sink 4 and the reinforcing frame 3 and is fastened to the protection plate 12. For a reason for the reduction of the quantity of vias on the PCB 11, refer to the following description:

The reinforcing frame 3 is fixedly connected to the PCB assembly 1 by using the first fastener 51, and the heat sink 4 is fixedly connected to the reinforcing frame 3 by using the second fastener 52. As shown in FIG. 2, the PCB 11 of the PCB assembly 1 is provided with a via for the first fastener 51 to pass through. Because the depth of the second fastener 52 that enters the reinforcing frame 3 is less than or equal to the thickness of the reinforcing frame 3, the second fastener 52 does not enter the PCB 11. In this case, the PCB 11 does not need to be provided with a via for the second fastener 52 to enter. Therefore, compared with a case in which the reinforcing frame 3 is fastened to the protection plate 12 by using screws and the heat sink 4 is also fastened to the protection plate 12 by using screws, it is clearly that, in this application, the quantity of vias on the PCB 11 can be reduced, and the reduction of the quantity of vias on the PCB 11 facilitates routing and component mounting on the surface of the PCB 11.

The fastener 5 passes through the heat sink 4 and the reinforcing frame 3, and is fastened in the protection plate 12 of the PCB assembly 1. As shown in FIG. 4, the heat sink 4 and the reinforcing frame 3 share the fastener 5. Therefore, compared with a case in which the reinforcing frame 3 is fastened to the protection plate 12 by using screws and the heat sink 4 is also fastened to the protection plate 12 by using screws, it is clearly that, in this application, the quantity of vias on the PCB 11 can be reduced, and the reduction of the quantity of vias on the PCB 11 facilitates routing on the surface of the PCB 11 and implements high-density routing on the surface of the PCB 11.

For example, if a case in a conventional technology is used, in which the reinforcing frame 3 is fixedly connected to the protection plate 12 by using four screws and the heat sink 4 is also fixedly connected to the protection plate 12 by using four screws, eight vias need to be disposed on the PCB 11 for the eight screws to pass through. If the case shown in FIG. 2 is used, in which the heat sink 4 is fastened to the reinforcing frame 3 by using the second fastener 52 and the reinforcing frame 3 is fastened to the protection plate 12 by using the first fastener 51, the reinforcing frame 3 is fixedly connected to the protection plate 12 by using four first fasteners 51, the heat sink 4 is fixedly connected to the reinforcing frame 3 by using four second fasteners 52, and none of the four second fasteners 52 is inserted into the PCB 11. Therefore, only four vias need to be disposed on the PCB 11 for the first fasteners 51 to pass through. If the case shown in FIG. 4 is used, in which the fastener 5 passes through the heat sink 4 and the reinforcing frame 3 and is fastened to the protection plate 12, each of four fasteners 5 passes through the heat sink 4 and the reinforcing frame 3 and is screwed into the protection plate 12. Therefore, only four vias need to be disposed on the PCB 11 for the four fasteners 5 to pass through.

It can be learned that, the quantity of vias on the PCB 11 of the PCB assembly 1 can be reduced, regardless of whether the heat sink 4 is fastened to the reinforcing frame 3 by using the second fastener 52 and the reinforcing frame 3 is fastened to the protection plate 12 by using the first fastener 51, or the fastener 5 passes through the heat sink 4 and the reinforcing frame 3 and is fastened to the protection plate 12.

The following describes the foregoing two fastening manners of the reinforcing frame 3 and the heat sink 4.

As described above, the reinforcing frame 3 may be fixedly connected to the protection plate 12 of the PCB assembly 1 by using the first fastener 51. As shown in FIG. 1, the first fastener 51 may be a screw. As shown in FIG. 2, the first fastener 51 passes through the reinforcing frame 3 and is fastened in the PCB assembly 1. For example, the first fastener 51 passes through the reinforcing frames 3 and the PCB 11, and is fastened in the protection plate 12.

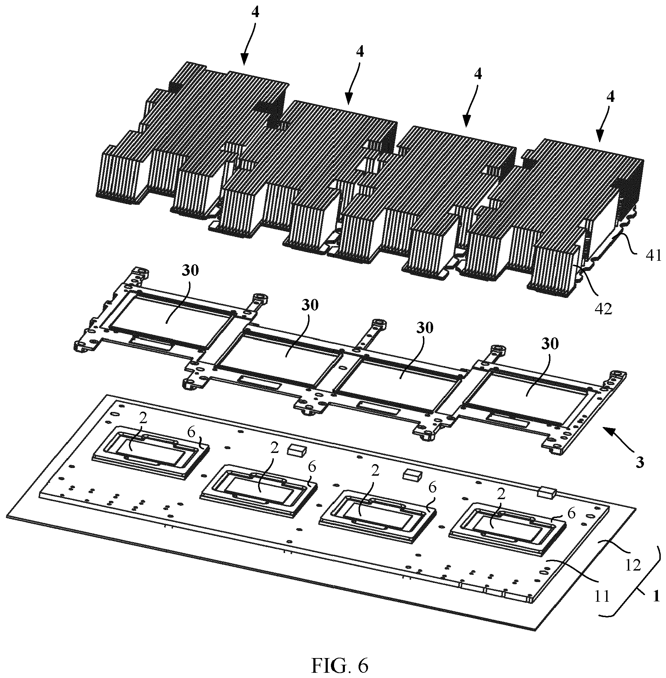

There are a plurality of first fasteners 51. For example, as shown in FIG. 1, there may be four or more first fasteners 51. The quantity of first fasteners 51 may be flexibly selected based on an actual situation, for example, may be selected based on a quantity of bare dies 2 included in the board. If there is one bare die 2, four first fasteners 51 may exist. If there are four bare dies 2 as shown in FIG. 6, ten first fasteners 51 may exist.

In an example, the first fastener 51 is fastened in the protection plate 12. For example, the protection plate 12 may be provided with threaded holes. The first fastener 51 being a screw is screwed into the threaded hole. The threaded hole may be a through hole with a thread on an inner wall, or may be a blind via with a thread on an inner wall. This is not limited in this embodiment.

It should be noted that, if the thickness of the protection plate 12 is relatively small, a depth of the threaded hole may be insufficient. In this case, referring to FIG. 2, pillars 121 may be disposed on the surface of the protection plate 12 that is near the PCB 11, and a threaded hole may be disposed in the pillar 121. The first fastener 51 is screwed into the threaded hole of the pillar 121. In this way, the depth of the threaded hole can be increased with help of the pillar 121, so that the first fastener 51 can be tightly screwed into the threaded hole.

As described above, the heat sink 4 is fixedly connected to the reinforcing frame 3 by using the second fastener 52. As shown in FIG. 1, the second fastener 52 may include a screw 521 and a first elastic component 522. As shown in FIG. 2, the screw 521 passes through the heat sink 4, and a depth of a part, of the screw that enters the reinforcing frame 3 is less than or equal to the thickness of the reinforcing frame 3. In this way, the screw 521 does not enter the PCB 11 but is fastened in the reinforcing frame 3, and the first elastic component 522 is compressed between a screw cap of the screw 521 and the heat sink 4.

There may also be a plurality of second fasteners 52. For example, as shown in FIG. 1, there may be four or more second fasteners 52. The quantity of second fasteners 52 may be flexibly selected based on an actual situation, for example, may be selected based on a quantity of heat sinks 4 included in the board. If there is one heat sink 4, four second fasteners 52 may exist. If there are four heat sinks 4 as shown in FIG. 6, 16 second fasteners 52 may exist.

As described above, the heat sink 4 includes a heat dissipation substrate 41 and heat dissipation fins 42. Correspondingly, as shown in FIG. 2, the screw 521 may pass through the heat dissipation substrate 41 and be fastened in the reinforcing frame 3, and the first elastic component 522 is compressed between the screw cap of the screw 521 and the heat dissipation substrate 41.

In an example, as shown in FIG. 2, the reinforcing frame 3 may be provided with threaded holes. The threaded hole may be a through hole with a thread on an inner wall, or may be a blind via with a thread on an inner wall. This is not limited in this embodiment. Correspondingly, the screw 521 passes through the heat dissipation substrate 41 of the heat sink 4 and is screwed into the threaded hole of the reinforcing frame 3, and the depth of the screw 521 that enters the reinforcing frame 3 is less than or equal to a depth of the threaded hole, so that the screw 521 does not enter the PCB 11. As the screw 521 does not enter the PCB 11, the PCB 11 does not need to be provided with a via for the screw 521 to enter, so as to reduce the quantity of vias on the PCB 11.

The first elastic component 522 may be a component having contractile elasticity, for example, may be a spring, an elastic fastening tool, or a compressible thermally conductive medium. A specific structural form of the first elastic component 522 is not limited in this embodiment, and a spring may be used as an example in the accompanying drawings.

The first elastic component 522 is compressed between the screw cap of the screw 521 and the heat sink 4, so that not only a tolerance between the bare die 2 and the heat sink 4 can be eliminated, but also the bare die 2 can reach close contact with a bottom of the heat sink 4, so as to accelerate heat transfer between the bare die 2 and the heat sink 4, and accelerate heat dissipation for the bare die 2.

This type of reinforcing frame 3 is fastened to the protection plate 12 by using the first fastener 51, and the heat sink 4 is fastened in the reinforcing frame 3 by using the second fastener 52. The second fastener 52 does not pass through the PCB 11, so that the PCB 11 has a relatively small quantity of vias. This facilitates routing and component mounting on the PCB 11.

As described above, the fastener 5 passes through the heat sink 4 and the reinforcing frame 3, and is fastened in the protection plate 12 of the PCB assembly 1.

There are a plurality of fasteners 5. For example, as shown in FIG. 1, there may be four or more fasteners 5. The quantity of fasteners 5 may be flexibly selected based on an actual situation, for example, may be selected based on a quantity of bare dies 2 included in the board. If there is one bare die 2, four fasteners 5 may exist. If there are four bare dies 2 as shown in FIG. 6, ten fasteners 5 may exist.

In one manner of the solution in which the fastener 5 passes through the heat sink 4 and the reinforcing frame 3, and is fastened in the protection plate 12 of the PCB assembly 1: The fastener 5 may include a stud 53, a nut 54, and a second elastic component 55. A position of the stud 53 that is near a first end has an outer thread, and a position of the stud 53 that is near a second end has an outer thread. The first end of the stud 53 successively passes through the heat sink 4, the reinforcing frame 3, and the PCB 11, and is screwed into the protection plate 12 of the PCB assembly 1. The second end of the stud 53 extends out of the heat dissipation substrate 41 of the heat sink 4, and the second elastic component 55 is located on a surface of the heat dissipation substrate 41 that is away from the reinforcing frame 3. The nut 54 is fastened at a position of the stud 53 that is near the second end, and the second elastic component 55 is compressed between the heat dissipation substrate 41 and the nut 54.

The second elastic component 55 may be a component having contractile elasticity, for example, may be a spring, an elastic fastening tool, or a compressible thermally conductive medium. A specific structural form of the second elastic component 55 is not limited in this embodiment, and a spring may be used as an example in the accompanying drawings.

In the other manner of the solution in which the fastener 5 passes through the heat sink 4 and the reinforcing frame 3, and is fastened in the protection plate 12 of the PCB assembly 1: As shown in FIG. 3, the fastener 5 may also include a stud 53, a nut 54, and a second elastic component 55. A difference from the foregoing fastener 5 is that an outer wall of the stud 53 has a boss 531, and the boss 531 may also be referred to as a step.

As shown in FIG. 4, a first end of the stud 53 passes through the reinforcing frame 3 and is fastened in the PCB assembly 1, and the boss 531 is located on a surface of the reinforcing frame 3 that is away from the PCB assembly 1; and a second end of the stud 53 passes through the heat sink 4. The nut 53 is fastened at a position of the stud 53 that is near the second end, and the second elastic component 55 is compressed between the nut 54 and the heat sink 4.

The stud 53 is screwed into the protection plate 12. For example, the protection plate 12 is provided with threaded holes. The threaded hole may be a through hole with a thread on an inner wall, or may be a blind via with a thread on an inner wall. This is not limited in this embodiment. The stud 53 may be screwed into the threaded hole in the protection plate 12. If the thickness of the protection plate 12 is relatively small, to tightly screw the stud 53 into the protection plate 12, correspondingly, referring to FIG. 4, pillars 121 may be disposed on the surface of the protection plate 12 that is near the PCB 11, and a threaded hole is disposed in the pillar 121. In this way, the stud 53 is screwed into the threaded hole of the pillar 121, and a depth of the threaded hole can be increased with help of the pillar 121, so that the stud 53 can be tightly screwed into the protection plate 12.

For example, the first end of the stud 53 passes through the reinforcing frame 3 and the PCB 11, an outer thread near the first end is screwed into the pillar of the protection plate 12, and the boss 531 of the stud 53 fits with the surface of the reinforcing frame 3 that is away from the PCB 11. Then, the heat sink 4 is placed on the surfaces of the bare die 2 and the reinforcing frame 3 that are away from the PCB 11, and the second end of the stud 53 passes through the heat dissipation substrate 41 of the heat sink 4. Afterwards, the second elastic component 55 and the nut 54 are mounted at positions of the stud 53 that are near the second end, and the second elastic component 55 is compressed between the heat dissipation substrate 41 and the nut 54, so that the heat dissipation substrate 41 of the heat sink 4 is fixedly connected to the reinforcing frame 3. In addition, the second elastic component 55 can further eliminate the tolerance between the bare die 2 and the heat sink 4, and the bare die 2 and the bottom of the heat sink 4 can be maintained in close contact, to accelerate heat transfer between the bare die 2 and the heat sink 4, and accelerate heat dissipation for the bare die 2.

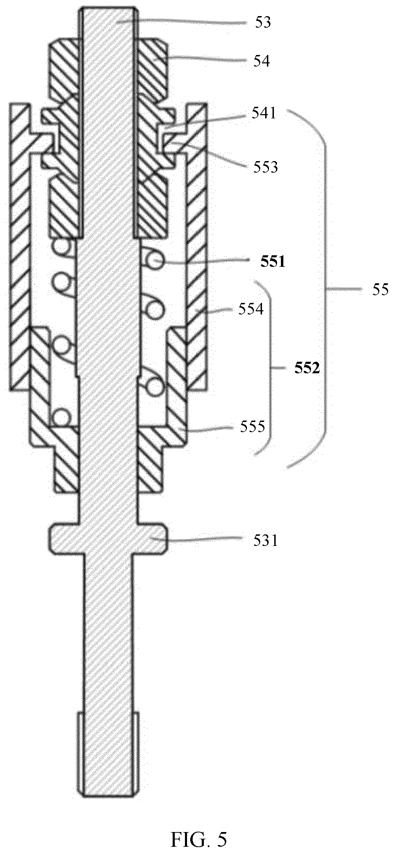

As shown in FIG. 5, the second elastic component 55 may include a telescopic member 551 and a housing 552. The housing 552 is sleeved on the stud 53 and located above the boss 531, and the housing 552 is snapped into the nut 54. The telescopic member 551 is located in the housing 552, and is compressed between the housing 552 and the nut 54.

The housing 552 serves to protect the second elastic component 55.

The housing 552 can move up and down along an axial direction of the stud 53 relative to the nut 54 in a telescopic motion of the telescopic member 551, and a movement stroke falls within a preset range. In this way, the second elastic component 55 can provide a buffering effect to eliminate the tolerance between the heat sink 4 and the bare die 2, and the heat sink 4 and the bare die 2 can be maintained in the fitted state.

In an example, a manner of snapping the housing 552 into the nut 54 may be as follows: As shown in FIG. 5, an inner wall of the housing 552 has a protrusion 553, an outer wall of the nut 54 has a groove 541, and the protrusion 553 is located in the groove 541. In this way, the housing 552 is snapped into the nut 54.

To enable the housing 552 to move up and down along the axial direction of the stud 53 relative to the nut 54, correspondingly, as shown in FIG. 5, a depth of the groove 541 along the axial direction of the stud 53 is greater than a height of the protrusion 553. In addition, a difference between the depth of the groove 541 and the height of the protrusion 553 falls within the foregoing preset range, that is, a stroke of up-down movement of the housing 552 relative to the nut 54.

In this way, the protrusion 553 cooperates with the groove 541, so that the housing 552 can be fixedly connected to the nut 54. The height of the protrusion 553 is set to be less than the depth of the groove 541 along the axial direction of the stud 53, so that the housing 552 can move up and down along the axial direction of the stud 53 with extension and retraction of the telescopic member 551, and the second elastic component 55 has the buffering effect.

In an example, the housing 552 may be a stepped housing, and an inner diameter of a bottom of the housing 552 may be less than an inner diameter of a top of the housing 552, so that the telescopic member 551 can be located in the housing 552 and the telescopic member 551 can be supported on a bottom surface of the housing 552. In this way, the telescopic member 551 is compressed between the bottom of the housing 552 and a bottom of the nut 54.

As shown in FIG. 5, the housing 552 may include a first housing 554 and a second housing 555. A bottom of the first housing 554 is connected to a top of the second housing 555. For example, the first housing 554 and the second housing 555 are integrally formed. For another example, the first housing 554 is threadedly connected to the second housing 555. As an example, an inner wall of the bottom of the first housing 554 has an inner thread, and an outer wall of the top of the second housing 555 has an outer thread, and the two housings are threadedly connected.

Correspondingly, an inner diameter of the first housing 554 and an inner diameter of the second housing 555 each are greater than an outer diameter of the stud 53, so that both the first housing 554 and the second housing 555 are sleeved outside the stud 53.

Correspondingly, the inner diameter of the first housing 554 is greater than an outer diameter of the telescopic member 551, and an inner diameter of a bottom of the second housing 555 is less than the outer diameter of the telescopic member 551, so that the telescopic member 551 can be located and compressed in the housing 552. In this way, the telescopic member 551 can be located in the first housing 554, and a bottom of the telescopic member 551 can be supported on an inner surface of the bottom of the second housing 555. Alternatively, an overall inner diameter of the second housing 555 is less than an outer diameter of the telescopic member 551. In this way, the telescopic member 551 can be located in the first housing 554, and the telescopic member 551 is supported on an outer surface of the top of the second housing 555.

In an example, the board may include one or more bare dies 2. For example, as shown in FIG. 6, the board includes a plurality of bare dies 2, and the plurality of bare dies 2 are located on a surface of the PCB assembly 1, for example, the plurality of bare dies 2 are located on a surface of the PCB 11. The plurality of bare dies 2 may use one heat sink 4 with a large size for heat dissipation, or the plurality of bare dies 2 may use a plurality of heat sinks 4 for heat dissipation. A quantity of bare dies 2 may be the same as or different from a quantity of heat sinks 4. This is not limited in this embodiment.

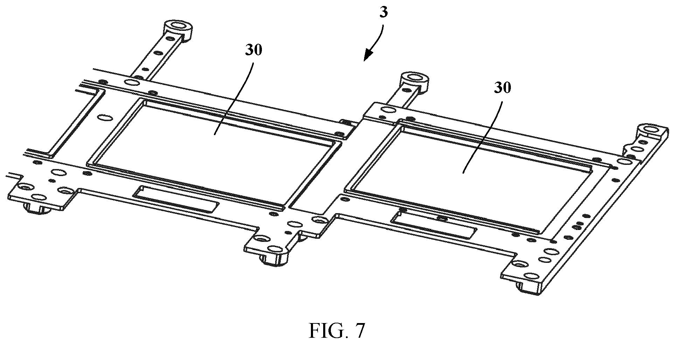

The plurality of bare dies 2 may share one reinforcing frame 3. For example, FIG. 7 is a schematic diagram of a partial structure of the reinforcing frame 3 in FIG. 6. The reinforcing frame 3 is grid-shaped, and includes a plurality of grids 30. Each bare die 2 is located in one grid 30, and a plurality of heat sinks 4 may be fastened to the reinforcing frame 3.

For a plurality of bare dies 2 to share one reinforcing frame 3, correspondingly, the reinforcing frame 3 is adapted to a region in which the plurality of bare dies 2 are located. For example, an area of the reinforcing frame 3 is adapted to an area of the region in which the plurality of bare dies 2 are located, and the grids 30 of the reinforcing frame 3 may one to one correspond to the bare dies 2. Alternatively, a quantity of grids 30 of the reinforcing frame 3 may be greater than a quantity of bare dies 2, and the grids 30 may be configured to mount not only the bare dies 2 but also other components of the board.

Compared with a case in which bare dies 2 one to one correspond to reinforcing frames 3, it is clearly that, in this case in which the plurality of bare dies 2 share one reinforcing frame 3, an area occupied by the reinforcing frame 3 on the surface of the PCB 11 can be reduced, and a quantity of vias disposed on the PCB 11 for fastening the reinforcing frame 3 can be reduced.

In addition, the reinforcing frame 3 has a relatively large area. When the reinforcing frame 3 is fastened to the surface of the PCB assembly 1, not only rigidity of the PCB 11 at the bare die 2 can be increased, but also overall rigidity of the PCB 11 can be increased, to mitigate deformation of the PCB 11.

In addition, because the plurality of heat sinks 4 are fastened to the reinforcing frame 3, the reinforcing frame 3 can be configured to fasten the plurality of heat sinks 4 together, to save a substrate configured to fasten a plurality of heat sinks 4 together. Once the substrate configured to fasten a plurality of heat sinks 4 is saved, a space occupied by the substrate on the board can be released, and the released space can be used to extend a height of heat dissipation fins 42 of the heat sink 4, so as to increase an area of the heat dissipation fins 42. This further increases a heat dissipation area of the heat sink 4, and improves a heat dissipation effect of the heat sink 4.

In addition, in the solution in which a plurality of heat sinks 4 are used for heat dissipation of the plurality of bare dies 2, the plurality of heat sinks 4 may be connected by using a heat pipe or a vapor chamber to form a conjoined heat sink, and the plurality of heat sinks 4 are connected. This conjoined heat sink formed by the plurality of heat sinks 4 can achieve a uniform temperature for each bare die 2. This avoids a case in which some bare dies 2 have a relatively high temperature due to poor heat dissipation, while some bare dies 2 have a relatively low temperature due to excessive heat dissipation.

The conjoined heat sink formed by the plurality of heat sinks 4 is fastened to the reinforcing frame 3, and can protect the heat pipe or the vapor chamber. Because the heat pipe or the vapor chamber usually uses a material of copper and has a relatively small thickness, the heat pipe or the vapor chamber may be easily damaged if there is no supporting plate. The conjoined heat sink formed by the plurality of heat sinks 4 is fastened to the reinforcing frame 3, so that the heat pipe or the vapor chamber is located on a same plane and is not bent and damaged. This protects the heat pipe or the vapor chamber.

In this embodiment of this application, the board includes a reinforcing frame. The reinforcing frame is located on a surface of a PCB assembly and surrounds a bare die. The reinforcing frame can increase rigidity of the PCB assembly at the corresponding bare die, so as to mitigate deformation of the PCB assembly at the bare die, and improve reliability of a connection between the bare die and the PCB assembly.

In addition, the reinforcing frame is fixedly connected to the PCB assembly, and a heat sink is fixedly connected to the reinforcing frame. Compared with a case in which the reinforcing frame is fixedly connected to the PCB assembly and the heat sink is also fixedly connected to the PCB assembly, it is clearly that, in this application, a quantity of vias on the PCB assembly can be reduced, and the reduction of the quantity of vias on the PCB assembly facilitates routing and component mounting on the PCB assembly and implements high-density routing on a surface of a PCB assembly.

In addition, in a solution in which the board includes a plurality of bare dies, the plurality of bare dies may share one reinforcing frame. The reinforcing frame is grid-shaped and includes a plurality of grids, and each bare die is located in the grid. In this solution, compared with a case in which bare dies one to one correspond to reinforcing frames, it is clearly that, in this application, an area occupied by the reinforcing frame on the PCB assembly can be reduced, and the quantity of vias on the PCB assembly can also be reduced, to implement high-density routing on the surface of the PCB assembly.

In addition, in a solution in which the board includes a plurality of heat sinks, the plurality of heat sinks may be fastened to one reinforcing frame, and the reinforcing frame fastens the plurality of heat sinks together. This can save a substrate configured to fasten a plurality of heat sinks together. Once the substrate configured to fasten a plurality of heat sinks is saved, a space occupied by the substrate on the board can be released, and the released space can be used to extend a height of heat dissipation fins of the heat sink, so as to increase an area of the heat dissipation fins. This further increases a heat dissipation area of the heat sink, and improves a heat dissipation effect of the heat sink.

An embodiment of this application further provides a board manufacturing method. The method is applied to the foregoing board, and the method includes the following steps.

In step 1, a bare die 2 is welded to a surface of a PCB assembly 1.

The PCB assembly 1 may include a PCB 11 and a protection plate 12. The PCB 11 is fastened to a surface of the protection plate 12.

In an example, a surface of the bare die 2 has solder balls, and a surface of the PCB 11 has pads. The solder balls of the bare die 2 may be welded to the surface of the PCB 11 by using solder to implement an electrical connection between the bare die 2 and the PCB 11.

In step 2, a reinforcing frame 3 is placed on the surface of the PCB assembly 1, and surrounds a periphery of the bare die 2.

In an example, the reinforcing frame 3 is placed on the surface of the PCB 11. The reinforcing frame 3 includes a grid 30, and the grid 30 surrounds the bare die 2.

In step 3, a heat sink 4 is placed on a surface of the bare die 2 that is away from the PCB assembly 1.

In an example, the heat sink 4 is configured to dissipate heat for the bare die 2. Therefore, the heat sink 4 is placed on the surface of the bare die 2 that is away from the PCB assembly 1.

In step 4, the reinforcing frame 3 is fixedly connected to the PCB assembly 1 by using fasteners 5, and the heat sink 4 is fixedly connected to the reinforcing frame 3.

In an example, a fastening manner may be as follows: The reinforcing frame 3 is fixedly connected to the protection plate 12 of the PCB assembly 1 by using first fasteners 51 in the fasteners 5, and the heat sink 4 is fixedly connected to the reinforcing frame 3 by using second fasteners 52 in the fasteners 5, as shown in FIG. 2. Another fastening manner is as follows: The fastener 5 passes through the heat sink 4 and the reinforcing frame 3, and is fastened in the protection plate 12 of the PCB assembly 1, as shown in FIG. 3 and FIG. 4.

It can be learned from the foregoing description that, the board includes the reinforcing frame 3. The reinforcing frame 3 is located on the surface of the PCB assembly 1 and surrounds the bare die 2. The reinforcing frame 3 can increase rigidity of the PCB assembly 1 at the corresponding bare die 2, so as to mitigate deformation of the PCB assembly 1 at the bare die 2, and improve reliability of a connection between the bare die 2 and the PCB assembly 1.

In addition, the reinforcing frame 3 is fixedly connected to the PCB assembly 1, and the heat sink 4 that performs heat dissipation for the bare die 2 is fixedly connected to the reinforcing frame 3. Compared with a case in which the reinforcing frame 3 is fixedly connected to the PCB assembly 1 and the heat sink 4 is also fixedly connected to the PCB assembly 1, it is clearly that, in this fastening manner, a quantity of vias on the PCB assembly 1 can be reduced, and the reduction of the quantity of vias on the PCB assembly 1 facilitates routing and component mounting on the PCB assembly 1 and implements high-density routing on a surface of the PCB 11.

In an example, if the fasteners 5 include the first fasteners 51 and the second fasteners 52. In this case, the foregoing step 4 may be performed in the following manner.

First, the first fastener 51 may be made to pass through the reinforcing frame 3 and be fastened in the PCB assembly 1.

For example, the first fastener 51 is made to pass through the reinforcing frame 3 and the PCB 11 of the PCB assembly 1, and is fastened in the protection plate 12 of the PCB assembly 1. The second fastener 52 is made to pass through the heat sink 4 and is fastened in the reinforcing frame 3.

In another example, the foregoing step 4 may alternatively be performed in the following manner: The fastener 5 is made to pass through the heat sink 4 and the reinforcing frame 3, and is fastened in the PCB assembly 1.

For example, the fastener 5 includes a stud 53, a nut 54, and a second elastic component 55. A position of the stud 53 that is near a first end has an outer thread, and a position of the stud 53 that is near a second end has an outer thread. First, the first end of the stud 53 is made to successively pass through the heat sink 4, the reinforcing frame 3, and the PCB 11, and is screwed into a pillar 121 in the protection plate 12 of the PCB assembly 1. The second end of the stud 53 extends out of a heat dissipation substrate 41 of the heat sink 4, and the second elastic component 55 is located on a surface of the heat dissipation substrate 41 that is away from the reinforcing frame 3. Then, the nut 54 is fastened at a position of the stud 53 that is near the second end, and the second elastic component 55 is compressed between the heat dissipation substrate 41 and the nut 54.

For another example, the fastener 5 includes a stud 53, a nut 54, and a second elastic component 55, and an outer wall of the stud 53 has a boss 531. The fastener 5 may be made to pass through the heat sink 4 and the reinforcing frame 3, and be fastened in the PCB assembly 1 according to the following process:

First, a first end of the stud 53 is made to pass through the reinforcing frame 3 and is fastened in the PCB assembly 1. The boss 531 is located on a surface of the reinforcing frame 3 that is away from the PCB assembly 1.

Then, the heat sink 4 is placed on the surface of the bare die 2 that is away from the PCB assembly 1, and a second end of the stud 53 passes through the heat sink 4.

Afterwards, the nut 54 is fastened at a position of the stud 53 that is near the second end. The second elastic component 55 is compressed between the heat sink 4 and the nut 54.

In this embodiment of this application, a board manufactured by using the foregoing method includes a reinforcing frame. The reinforcing frame is located on a surface of a PCB assembly and surrounds a bare die. The reinforcing frame can increase rigidity of the PCB assembly at the corresponding bare die, so as to mitigate deformation of the PCB assembly at the bare die, and improve reliability of a connection between the bare die and the PCB assembly.

In addition, the reinforcing frame is fixedly connected to the PCB assembly, and a heat sink is fixedly connected to the reinforcing frame. Compared with a case in which the reinforcing frame is fixedly connected to the PCB assembly and the heat sink is also fixedly connected to the PCB assembly, it is clearly that, in this application, a quantity of vias on the PCB assembly can be reduced, and the reduction of the quantity of vias on the PCB assembly facilitates routing and component mounting on the PCB assembly and implements high-density routing on a surface of a PCB assembly.

This application further provides an electronic device. The electronic device may be any device including a bare die, for example, a communications device or a server device. The electronic device includes the foregoing board.

As described above, the board includes a reinforcing frame. The reinforcing frame is located on a surface of a PCB assembly and surrounds the bare die. The reinforcing frame can increase rigidity of the PCB assembly at the corresponding bare die, so as to mitigate deformation of the PCB assembly at the bare die, and improve reliability of a connection between the bare die and the PCB assembly.

In addition, the reinforcing frame is fixedly connected to the PCB assembly, and a heat sink that performs heat dissipation for the bare die is fixedly connected to the reinforcing frame. Compared with a case in which the reinforcing frame is fixedly connected to the PCB assembly and the heat sink is also fixedly connected to the PCB assembly, it is clearly that, in this application, a quantity of vias on the PCB assembly can be reduced, and the reduction of the quantity of vias on the PCB assembly facilitates routing and component mounting on the PCB assembly and implements high-density routing on a surface of the PCB assembly.

The foregoing descriptions are merely an embodiment of this application, but are not intended to limit this application. Any modification, equivalent replacement, or improvement made without departing from the principle of this application should fall within the protection scope of this application.

## Claims

1. A board, wherein the board comprises a printed circuit board, PCB, assembly (1), a bare die (2), a reinforcing frame (3), a heat sink (4), and fasteners (5), wherein
both the bare die (2) and the reinforcing frame (3) are located on a surface of the PCB assembly (1), the bare die (2) is located in the reinforcing frame (3), and the reinforcing frame (3) is fixedly connected to the PCB assembly (1) by using the fastener (5); and
the heat sink (4) is located on a surface of the bare die (2) that is away from the PCB assembly (1), and the heat sink (4) is fixedly connected to the reinforcing frame (3) by using the fastener (5).

2. The board according to claim 1, wherein the fasteners (5) comprise first fasteners (51) and second fasteners (52);
the first fastener (51) passes through the reinforcing frame (3) and is fastened in the PCB assembly (1); and
the second fastener (52) passes through the heat sink (4) and is fastened in the reinforcing frame (3), and a depth of a part, of the second fastener (52) that enters the reinforcing frame (3) is less than or equal to a thickness of the reinforcing frame (3).

3. The board according to claim 2, wherein the second fastener (52) comprises a screw (521) and a first elastic component (522); and
the screw (521) passes through the heat sink (4) and is fastened in the reinforcing frame (3), a depth of a part, of the screw (521) that enters the reinforcing frame (3) is less than or equal to the thickness of the reinforcing frame (3), and the first elastic component (522) is compressed between a screw cap of the screw (521) and the heat sink (4).

4. The board according to claim 1, wherein the fastener (5) passes through the heat sink (4) and the reinforcing frame (3), and is fastened in the PCB assembly (1).

5. The board according to claim 4, wherein the fastener (5) comprises a stud (53), a nut (54), and a second elastic component (55), and an outer wall of the stud (53) has a boss (531);
a first end of the stud (53) passes through the reinforcing frame (3) and is fastened in the PCB assembly (1), and the boss (531) is located on a surface of the reinforcing frame (3) that is away from the PCB assembly (1); and a second end of the stud (53) passes through the heat sink (4); and
the nut (54) is fastened at a position of the stud (53) that is near the second end, and the second elastic component (55) is compressed between the nut (54) and the heat sink (4).

6. The board according to claim 5, wherein the second elastic component (55) comprises a telescopic member (551) and a housing (552);
the housing (552) is sleeved outside the stud (53) and located above the boss (531), and the housing (552) is snapped into the nut (54); and
the telescopic member (551) is located in the housing (552) and is compressed between the housing (552) and the nut (54).

7. The board according to claim 6, wherein an inner wall of the housing (552) has a protrusion (553), an outer wall of the nut (54) has a groove (541), a depth of the groove (541) is greater than a height of the protrusion (553), and the protrusion (553) is located in the groove (541).

8. The board according to any one of claims 1 to 7, wherein there are a plurality of bare dies (2) and a plurality of heat sinks (4);
the reinforcing frame (3) is grid-shaped and comprises a plurality of grids (30), and each bare die (2) is located in one grid (30); and
the plurality of heat sinks (4) each are fixedly connected to the reinforcing frame (3).

9. The board according to any one of claims 1 to 8, wherein a material of the reinforcing frame (3) is a metal; and
the board further comprises an insulation layer, and the insulation layer is located between the reinforcing frame (3) and the PCB assembly (1).

10. A board manufacturing method, wherein the method is applied to the board according to any one of claims 1 to 9, and the method comprises:
welding a bare die (2) to a surface of a PCB assembly (1);
placing a reinforcing frame (3) on the surface of the PCB assembly (1), wherein the reinforcing frame (3) surrounds a periphery of the bare die (2);
placing a heat sink (4) on a surface of the bare die (2) that is away from the PCB assembly (1); and
fixedly connecting, by using fasteners (5), the reinforcing frame (3) to the PCB assembly (1) and the heat sink (4) to the reinforcing frame (3).

11. The method according to claim 10, wherein the fasteners (5) comprise first fasteners (51) and second fasteners (52); and
the fixedly connecting, by using fasteners (5), the reinforcing frame (3) to the PCB assembly (1) and the heat sink (4) to the reinforcing frame (3) comprises:
making the first fastener (51) pass through the reinforcing frame (3), and fastening the first fastener (51) in the PCB assembly (1); and
making the second fastener (52) pass through the heat sink (4), and fastening the second fastener (52) in the reinforcing frame (3), wherein a depth of a part, of the second fastener (52) that enters the reinforcing frame (3) is less than or equal to a thickness of the reinforcing frame (3).

12. The method according to claim 10, wherein the fixedly connecting, by using fasteners (5), the reinforcing frame (3) to the PCB assembly (1) and the heat sink (4) to the reinforcing frame (3) comprises:
making the fastener (5) pass through the heat sink (4) and the reinforcing frame (3), and fastening the fastener (5) in the PCB assembly (1).

13. The method according to claim 12, wherein the fastener (5) comprises a stud (53), a nut (54), and a second elastic component (55), and an outer wall of the stud (53) has a boss (531);
the making the fastener (5) pass through the heat sink (4) and the reinforcing frame (3), and fastening the fastener (5) in the PCB assembly (1) comprises:
making a first end of the stud (53) pass through the reinforcing frame (3) and fastening the first end of the stud (53) in the PCB assembly (1), wherein the boss (531) is located on a surface of the reinforcing frame (3) that is away from the PCB assembly (1); and making a second end of the stud (53) pass through the heat sink (4); and
fastening the nut (54) at a position of the stud (53) that is near the second end, wherein the second elastic component (55) is compressed between the heat sink (4) and the nut (54).

14. An electronic device, wherein the electronic device comprises the board according to any one of claims 1 to 9.
